(19) Europäisches Patentamt / European Patent Office / Office européen des brevets

(11) **EP 2 012 428 B1**

(12) **EUROPEAN PATENT SPECIFICATION**

(45) Date of publication and mention
of the grant of the patent:
**28.03.2012 Bulletin 2012/13**

(51) Int Cl.:
*H03H 9/25* *(2006.01)*     *H03H 9/145* *(2006.01)*

(21) Application number: **07740994.4**

(22) Date of filing: **04.04.2007**

(86) International application number:
**PCT/JP2007/057558**

(87) International publication number:
**WO 2007/125734 (08.11.2007 Gazette 2007/45)**

(54) **ELASTIC SURFACE WAVE DEVICE**

ELASTISCHE OBERFLÄCHENWELLENVORRICHTUNG

DISPOSITIF À ONDE DE SURFACE ÉLASTIQUE

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **24.04.2006 JP 2006118949**

(43) Date of publication of application:
**07.01.2009 Bulletin 2009/02**

(73) Proprietor: **MURATA MANUFACTURING CO., LTD. Nagaokakyo-shi, Kyoto 617-8555 (JP)**

(72) Inventors:
• **NISHIYAMA, Kenji**
**Nagaokakyo-shi,**
**Kyoto 617-8555 (JP)**
• **NAKAO, Takeshi**
**Nagaokakyo-shi,**
**Kyoto 617-8555 (JP)**
• **KADOTA, Michio**
**Nagaokakyo-shi,**
**Kyoto 617-8555 (JP)**

(74) Representative: **Zimmermann, Tankred Klaus et al Schoppe, Zimmermann, Stöckeler & Zinkler Patentanwälte Postfach 246 82043 Pullach bei München (DE)**

(56) References cited:
**WO-A1-2005/034347     JP-A- 2005 354 430**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

Technical Field

The present invention relates to a surface acoustic wave device used as, for example, a resonator and a band pass filter. In particular, the present invention relates to a surface acoustic wave device having a structure in which an IDT electrode and a silicon oxide film are disposed on a $LiNbO_3$ substrate and taking advantage of the Rayleigh wave.

Background Art

Band pass filters used for RF stages of cellular phones and the like are required to be broadband and have good temperature characteristics. Therefore, a surface acoustic wave device in which an IDT electrode has been disposed on a piezoelectric substrate formed from a rotated Y-cut x-propagation $LiTaO_3$ substrate or a rotated Y-cut x-propagation $LiNbO_3$ substrate and a silicon oxide film has been disposed in such a way as to cover the IDT electrode has been used previously. Regarding this type of piezoelectric substrate, the temperature coefficient of resonant frequency takes on a negative value. Therefore, in order to improve the temperature characteristic, the silicon oxide film having a positive temperature characteristic of resonant frequency is disposed in such a way as to cover the IDT electrode.

However, regarding such a structure, in the case where the IDT electrode is formed from general-purpose Al or an alloy primarily containing Al, a satisfactory reflection coefficient of the IDT electrode cannot be obtained. Consequently, there is a problem in that a ripple is likely to occur in the resonant characteristic.

In order to solve the above-described problems, the following Patent Document 1 discloses a surface acoustic wave device in which an IDT electrode primarily composed of a metal having a density larger than that of Al is disposed on a piezoelectric substrate formed from $LiNbO_3$ having an electromechanical coefficient $K^2$ of 0.025 or more, a first silicon oxide film having a film thickness equal to the thickness of the electrode is disposed in a region other than the region in which the IDT electrode is disposed, and a second silicon oxide film is laminated in such a way as to cover the electrode and the first silicon oxide film.

In the surface acoustic wave device described in Patent Document 1, the density of the above-described IDT electrode is specified to be 1.5 times or more larger than the density of the first silicon oxide film, and it is described that the reflection coefficient of the IDT electrode is thereby increased satisfactorily and a ripple which occurs in the resonant characteristic can be suppressed.

In Patent Document 1, the Rayleigh wave is used, Au, Cu, and the like are exemplified as the material for the above-described electrode, a configuration in which in the case where the electrode is formed from Au, the film thickness thereof is specified to be $0.0017\lambda$ to $0.06\lambda$ is disclosed, and it is shown that in particular, if the film thickness is specified to be $0.0017\lambda$ to $0.03\lambda$, the electromechanical coefficient $K^2$ of the Rayleigh wave can increase. Furthermore, as for the above-described $LiNbO_3$ substrate, a $LiNbO_3$ substrate represented by Eulerian angles of $(0°\pm5°, 38°\pm10°, 0°)$ is shown, and a configuration in which the film thickness of the above-described second silicon oxide film is specified to be within the range of $0.15\lambda$ to $0.4\lambda$ is shown, where the wavelength of the surface acoustic wave is assumed to be $\lambda$.
Patent Document 1: WO2005-034347

Disclosure of Invention

In recent years, regarding surface acoustic wave devices as well, the frequencies have become still higher. Consequently, the pitch of electrode fingers of the IDT electrode has become small and the width dimension of the electrode finger itself has also become small. As a result, the wiring resistance increases and the loss in the surface acoustic wave device is likely to increase.

An increase in film thickness of the electrode is good enough for reducing the loss in the surface acoustic wave device. However, as described in, for example, Patent Document 1, regarding the surface acoustic wave device taking advantage of the Rayleigh wave in the past, the film thickness of the IDT electrode composed of Au is specified to be $0.06\lambda$ at the maximum. The reason for this is believed to be that if the film thickness of the IDT electrode composed of Au is increased up to $0.06\lambda$, the response of the SH wave increases sharply, and a large spurious appears between the resonant frequency and the anti-resonant frequency. Therefore, in Patent Document 1, in the case where the IDT electrode is formed from Au, the thickness thereof is specified to be within the range of $0.0017\lambda$ to $0.06\lambda$, and preferably $0.0017\lambda$ to $0.03\lambda$.

Consequently, in the case where higher frequencies are employed, the pitch of electrode fingers is reduced, and the width dimension of electrode finger is reduced, the film thickness of the electrode cannot be increased to a large extent. Therefore, the wiring resistance increases and the loss is like to increase.

Furthermore, as described above, regarding the surface acoustic wave device including the first and the second silicon oxide films, the temperature characteristic of resonant frequency is improved by disposition of the silicon oxide film, but there is a problem in that the characteristic is varied because of variations in film thickness of the silicon oxide film.

JP 2005-354430 A describes a SAW transducer with a plurality of concatenated basic ranges each having a width equivalent to a wavelength $\lambda$ of a stimulated SAW is located on a 128±5° rotation Y-cut X propagation lithium niobate substrate. Each of the basic ranges includes a positive electrode finger and a negative electrode finger, and the positive electrode finger and the negative electrode finger are arranged in a way that the center distance is almost $\lambda/2$. When Au is used for the electrode material, a relation of the electrode film thickness H/$\lambda$ and the electrode width W/$\lambda$ normalized by the wavelength $\lambda$ is 0.18≤W/$\lambda$<0.42 in the case of H/$\lambda$<0.005, and 0.08≤W/$\lambda$<0.25 in the case of H/$\lambda$≥0,005.

It is an object of the present invention to solve the above-described problems in the related art and provide a surface acoustic wave device taking advantage of the Rayleigh wave, wherein an increase in the loss does not occur easily even when the pitch of electrode fingers is reduced and the width dimension of electrode finger is reduced in order to employ higher frequencies.

This object is achieved by a surface acoustic device of claim 1.

According to the present invention, a surface acoustic wave device taking advantage of the Rayleigh wave is provided, the device characterized by including a LiNbO$_3$ substrate represented by Eulerian angles of (0°±5°, θ±5°, 0°±10°), an electrode which is disposed on the above-described LiNbO$_3$ substrate and which includes an IDT electrode primarily containing Au, a first silicon oxide film disposed in a region other than the region in which the above-described electrode is disposed, the first silicon oxide film having a film thickness equal to the thickness of the above-described electrode, and a second silicon oxide film disposed in such a way as to cover the above-described electrode and the first silicon oxide film, wherein the film thickness of the above-described electrode is within the range of 0.062$\lambda$ to 0.14$\lambda$, where $\lambda$ represents the wavelength of a surface acoustic wave, and θ of the above-described Eulerian angles of (0°±5°, θ±5°, 0°±10°) is specified to be within the range satisfying the following Formula (1).

[Mathematical formula 1]

$$\theta = 31.72 - 206.92 \times \exp(-1 \times T_{Au}/0.0138) \qquad \text{Formula (1)}$$

where $T_{Au}$: a value of Au electrode film thickness normalized with the wavelength $\lambda$

Regarding the surface acoustic wave device according to the present invention, preferably the film thickness H of the second silicon oxide film is specified to be within the range of 0.15$\lambda$ to 0.50$\lambda$, and in that case, the electromechanical coefficient $K^2$ of the Rayleigh wave is allowed to become 6% or more, and broadening of the band can be achieved easily.

(Advantage)

In the surface acoustic wave device taking advantage of the Rayleigh wave according to the present invention, the electrode including an IDT electrode primarily containing Au is disposed on the LiNbO$_3$ substrate and the above-described first and the second silicon oxide films are disposed, and the film thickness of the electrode is specified to be within the above-described specific range, that is, a large 0.062$\lambda$ or more. Therefore, the electric resistance can be reduced and, thereby, the loss can be reduced even when higher frequencies are employed. In addition, since θ of the Eulerian angle of the LiNbO$_3$ substrate is specified to be within the above-described specific range, the electromechanical coefficient of the Rayleigh wave is not reduced easily.

Consequently, according to the present invention, a broadband surface acoustic wave device which can be adapted to higher frequencies easily and which exhibits a reduced loss can be provided.

Brief Description of Drawings

[Fig. 1] Fig. 1 (a) and (b) are a schematic plan view of a surface acoustic wave device according to an embodiment of the present invention and a magnified partial cutaway front sectional view showing a key portion thereof under magnification.

[Fig. 2] Fig. 2 is a diagram showing changes in electromechanical coefficient $K^2$ of the Rayleigh wave in the case where the thickness of an IDT electrode composed of Au and θ of the Eulerian angle are changed.

[Fig. 3] Fig. 3 is a diagram showing changes in electromechanical coefficient $K^2$ of the SH wave in the case where the thickness of an IDT electrode composed of Au and θ of the Eulerian angle are changed.

[Fig. 4] Fig. 4 is a diagram showing changes in sound velocities of the Rayleigh wave and the SH wave in the case where the film thickness of the IDT electrode composed of Au is changed.

[Fig. 5] Fig. 5 is a diagram showing changes in electromechanical coefficient of the Rayleigh wave in the case where the film thickness of the IDT electrode is changed.

[Fig. 6] Fig. 6 is a diagram showing changes in electromechanical coefficient $K^2$ of the Rayleigh wave due to changes in θ of the Eulerian angle in the case where the film thickness of the second silicon oxide film is specified to be 0.2λ, 0.3λ, or 0.4λ.

[Fig. 7] Fig. 7 is a diagram showing changes in electromechanical coefficient $K^2$ of the SH wave due to changes in θ of the Eulerian angle in the case where the film thickness of the second silicon oxide film is specified to be 0.2λ, 0.3λ, or 0.4λ.

[Fig. 8] Fig. 8 is a diagram showing changes in electromechanical coefficient $K^2$ of the SH wave due to changes in θ of the Eulerian angle in the case where the film thickness of the IDT electrode composed of Au is 0.02λ and in the case where the film thickness of the second silicon oxide film is 0.2λ, 0.3λ, or 0.4λ.

[Fig. 9] Fig. 9 is a diagram showing the impedance characteristic and the phase characteristic of surface acoustic wave devices of an embodiment and first and second comparative examples.

[Fig. 10] Fig. 10 is a diagram showing the impedance characteristic and the phase characteristic of a surface acoustic wave device of an embodiment in the case where the film thickness of the second silicon oxide film is specified to be 0.34λ, 0.29λ, or 0.24λ.

Reference Numerals

1 surface acoustic wave device
2 LiNbO$_3$ substrate
3 IDT electrode
4,5 reflector
6 first silicon oxide film
7 second silicon oxide film

Best Modes for Carrying Out the Invention

The present invention will be made clear by describing the specific embodiments of the present invention below with reference to the drawings.

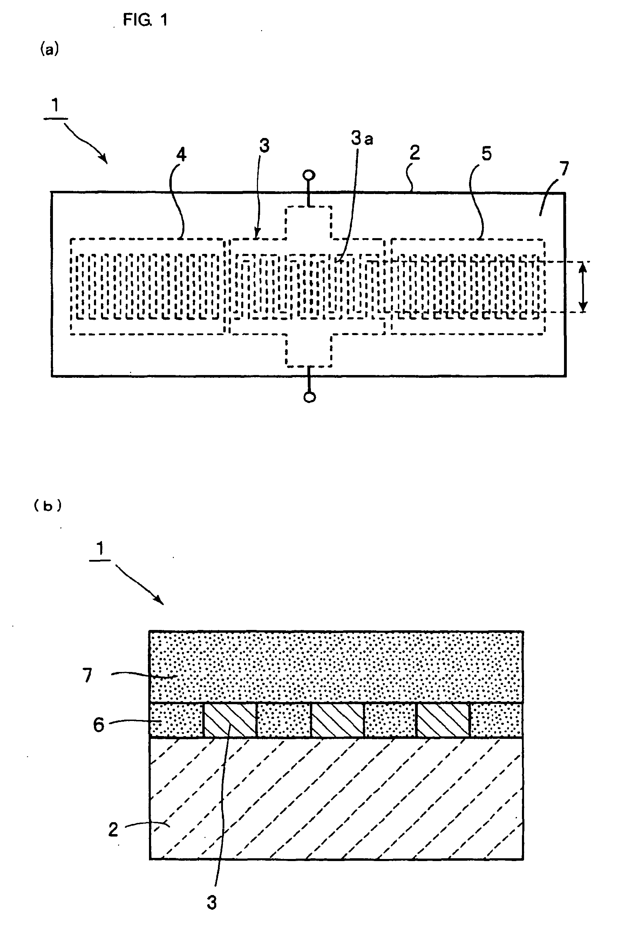

Fig. 1 (a) is a schematic plan view of a surface acoustic wave device according to an embodiment of the present invention, and (b) is a magnified partial cutaway front sectional view showing a key portion thereof.

A surface acoustic wave device 1 is formed by using a rotated Y-cut x-propagation LiNbO$_3$ substrate 2. The crystal orientation of the LiNbO$_3$ substrate 2 is specified by Eulerian angles of (0°±5°, θ, 0°±10°).

Furthermore, as shown in Fig. 1 (b), an IDT electrode 3 is disposed on the LiNbO$_3$ substrate 2. As shown in Fig. 1 (a), reflectors 4 and 5 are disposed on both sides of the IDT electrode 3 in a surface acoustic wave propagation direction.

A first silicon oxide film 6 is disposed in a region other than the region in which these electrodes are disposed. The film thickness of the first silicon oxide film 6 is specified to be equal to the film thicknesses of the IDT electrode 3 and the reflectors 4 and 5. Furthermore, a second silicon oxide film 7 is disposed in such a way as to cover these electrodes 3 to 5 and the first silicon oxide film 6.

In the surface acoustic wave device 1, the LiNbO$_3$ substrate has a negative temperature coefficient of resonant frequency. On the other hand, the silicon oxide films 6 and 7 have positive temperature coefficients of resonant frequency. Therefore, the frequency characteristic can be improved.

In addition, the density of the electrode including the IDT electrode 3 is specified to be 1.5 times or more larger than the density of the first silicon oxide film 6. That is, in the present embodiment, the IDT electrode 3 is formed from Au. Therefore, the density of the IDT electrode 3 is 19.3 g/cm$^3$. On the other hand, the density of the first silicon oxide film is 2.21 g/cm$^3$.

Consequently, as is disclosed in the above-described Patent Document 1, the reflection coefficient of the IDT electrode 3 can be increased. It is thereby made possible to suppress a ripple which appears in the resonant characteristic.

The surface acoustic wave device 1 of the present embodiment is further characterized in that the film thickness of the above-described IDT electrode 3 is within the range of 0.062λ to 0.14λ, where λ represents the wavelength of a surface acoustic wave, and θ of the Eulerian angles of (0°±5°, 0±5°, 0°±10°) of the LiNbO$_3$ substrate 2 is specified to be within the range satisfying the following Formula (1). That is, since the film thickness of the IDT electrode 3 is specified to be a large 0.062λ or more, the electrode resistance can be reduced. Consequently, the loss can be reduced even when higher frequencies are employed. Furthermore, since θ of the Eulerian angle is specified to be within a specific range, the electromechanical coefficient of the Rayleigh wave is not reduced easily.

[Mathematical formula 2]

$$\theta = 31.72 - 206.92 \times \exp(-1 \times T_{Au}/0.0138) \qquad \text{Formula (1)}$$

where $T_{Au}$: a value of Au electrode film thickness normalized with the wavelength λ

This will be described with reference to specific experimental examples.

(First experimental example)

Regarding Rayleigh wave which is excited on the LiNbO$_3$ substrate 2 represented by the Eulerian angles of (0°, 20° to 50°, 0°) and the SH wave which becomes a spurious, calculation was conducted by a finite element method. As shown in Fig. 1 (b), in a calculation model, the upper surface of a second silicon oxide film had a flat structure, an IDT electrode was formed from Au, and first and second silicon oxide films 6 and 7 were formed from SiO$_2$ films. The duty of the IDT electrode was specified to be 0.50, and the film thickness of the SiO$_2$ film constituting the second silicon oxide film 7 was specified to be a thickness of 0.3λ.

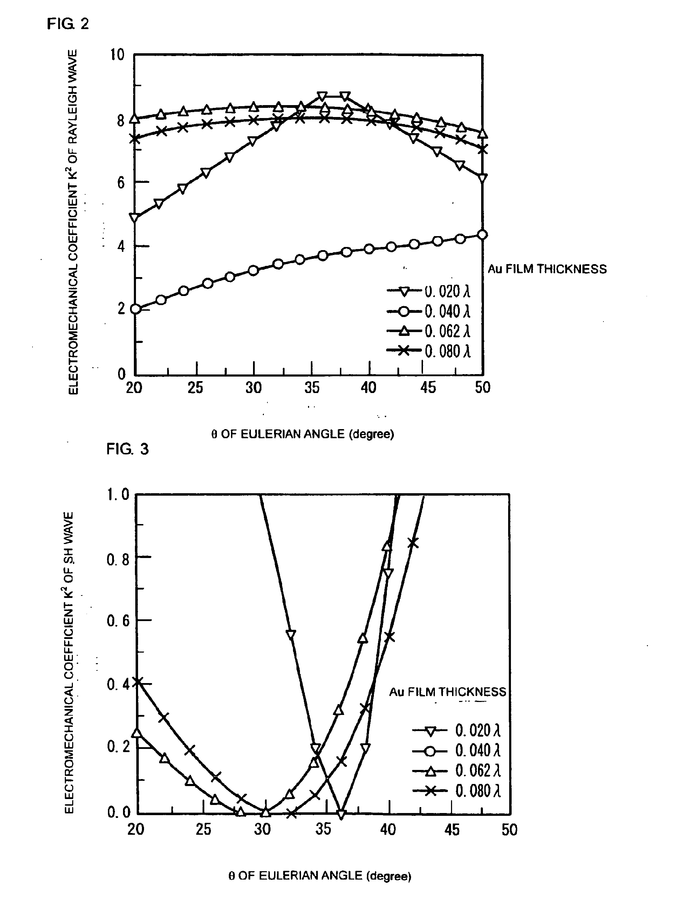

Changes in the electromechanical coefficient K$^2$ of the Rayleigh wave in the case where the film thickness of the IDT electrode 3 was specified to be 0.020λ, 0.040λ, 0.062λ, or 0.080λ and θ of the Eulerian angle was changed are shown in Fig. 2. Furthermore, changes in the electromechanical coefficient K$^2$ of the SH wave, which became a spurious, in the case where the film thickness of the IDT electrode was specified to be 0.020λ, 0.040λ, 0.062λ, or 0.080λ and θ of the Eulerian angle was changed are shown in Fig. 3.

As is clear from Fig. 2 and Fig. 3, in the case where the film thickness of the IDT electrode 3 composed of Au is 0.062λ or more, both of the dependence of the electromechanical coefficient K$^2$ of the Rayleigh wave and the dependence of the electromechanical coefficient K$^2$ of the SH wave on θ of the Eulerian angle change. That is, regarding the Rayleigh wave, as is clear from Fig. 2, in the case where the film thickness of the IDT electrode is 0.04λ or less, the electromechanical coefficient K$^2$ of the Rayleigh wave is small, and when the film thickness is a small 0.02λ or less, the electromechanical coefficient K$^2$ is changed significantly due to θ of the Eulerian angle. In contrast to this, in the case where the film thickness of the IDT electrode is 0.062λ or more, it is clear that the electromechanical coefficient K$^2$ of the Rayleigh wave is a high 6% or more, and changes due to θ of the Eulerian angle are small.

On the other hand, as is clear from Fig. 3, the electromechanical coefficient K$^2$ of the SH wave changes significantly as θ of the Eulerian angle changes. Incidentally, in the case where the film thickness of the IDT electrode 3 is 0.02λ, the electromechanical coefficient K$^2$ of the SH wave, which becomes a spurious, becomes a local minimum in the vicinity of θ = 36°, whereas in the case where the electrode film thickness is 0.062λ or 0.08λ, the electromechanical coefficient of the SH wave becomes a local minimum in the vicinity of θ = 30°. By the way, in the case where the film thickness of the IDT electrode is 0.04λ, the electromechanical coefficient of the SH wave was a very high 5% when θ of the Eulerian angle was 36° and, therefore, cannot be shown in Fig. 3.

Consequently, as is clear from Fig. 3, θ at which the electromechanical coefficient K$^2$ of the SH wave serving as a spurious becomes a minimum shifts from the vicinity of θ = 36° to the vicinity of 30° in the case where the film thickness of the IDT electrode composed of Au is 0.062λ or more.

Previously, it has been believed that in the case where the Rayleigh wave is used, an SH wave spurious increases as the film thickness of the IDT electrode 3 increases. That is, as described above, for example, in the case where the electrode film thickness was 0.04λ and θ of the Eulerian angle was 36°, the electromechanical coefficient K$^2$ of the SH wave was a very high 5%.

On the other hand, in the case where the film thickness is specified to be 0.062λ or more, as is clear from Fig. 3, the electromechanical coefficient K$^2$ of the SH wave is about 0.2% to 0.4% when θ is in the vicinity of 36°, but is a very small 0.05% or less in the vicinity of θ = 30°.

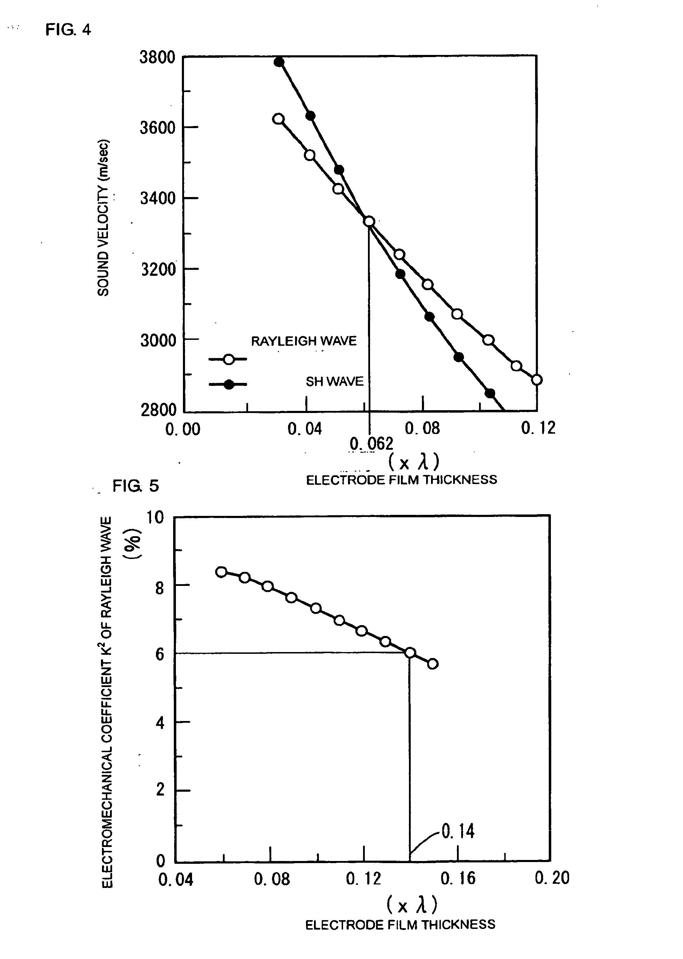

The reason the θ dependence of the electromechanical coefficient K$^2$ of the SH wave and the θ dependence of the electromechanical coefficient K$^2$ of the Rayleigh wave change at the border in the vicinity of 0.06λ in film thickness of the IDT electrode composed of Au, as described above, is believed that, as shown in Fig. 4, the sound velocity of the Rayleigh wave and the sound velocity of the SH wave intersect at a film thickness of the IDT electrode 3 of 0.062λ. That is, as shown in Fig. 4, the sound velocities of the SH wave and the Rayleigh wave decrease as the film thickness of the IDT electrode increases, but when the film thickness becomes 0.062λ or more, the sound velocity of the Rayleigh wave exceeds the sound velocity of the SH wave.

Therefore, as shown in Fig. 2 and Fig. 3, it is believed that when the film thickness of the IDT electrode becomes 0.062λ or more, the sound velocity of the above-described Rayleigh wave and the sound velocity of the SH wave are reversed and, thereby, the θ dependence of the electromechanical coefficient $K^2$ of the Rayleigh wave and the θ dependence of the electromechanical coefficient $K^2$ of the SH wave are changed.

Fig. 5 is a diagram showing changes in electromechanical coefficient $K^2$ of the Rayleigh wave due to the film thickness of the IDT electrode composed of Au. Here, the duty of the IDT electrode 3 was specified to be 0.50, and the film thickness of a $SiO_2$ film serving as the second silicon oxide film 7 was specified to be 0.3λ.

As is clear from Fig. 5, the electromechanical coefficient $K^2$ of the Rayleigh wave tends to decrease as the film thickness of the IDT electrode 3 composed of Au increases. However, it is clear that if the film thickness of the IDT electrode 3 is 0.14λ or less, the electromechanical coefficient $K^2$ of the Rayleigh wave shows a satisfactorily high value of 6% or more. Therefore, it is necessary that the film thickness of the IDT electrode 3 is specified to be 0.14λ or less in order to allow the electromechanical coefficient $K^2$ to become a satisfactorily high value of 6% or more.

In the present invention, the film thickness of the IDT electrode 3 composed of Au is specified to be 0.062λ or more and, thereby, the film thickness of the IDT electrode is increased satisfactorily, and the electrode resistance is reduced. In this case, on the basis of the results shown in Fig. 2 and Fig. 3, a spurious due to the SH wave can be reduced satisfactorily and, in addition, the electromechanical coefficient $K^2$ of the Rayleigh wave is allowed to become a satisfactorily high value of 6% or more by selecting θ of the Eulerian angle, as described later. In particular, the electromechanical coefficient $K^2$ of the Rayleigh wave can be increased to 6% or more reliably by specifying the film thickness of the IDT electrode to be 0.14λ or less, as described above.

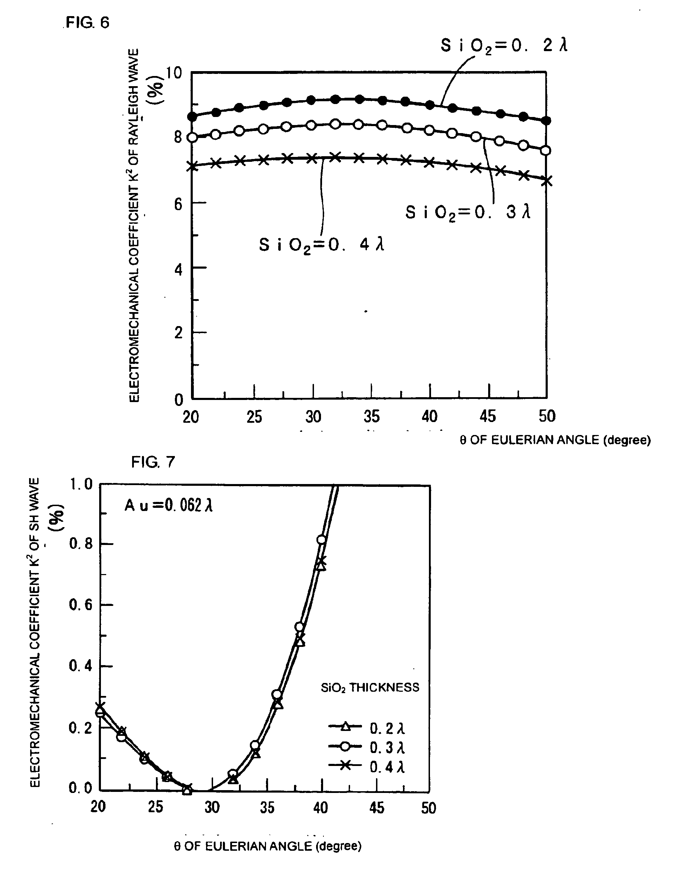

Fig. 6 is a diagram showing changes in electromechanical coefficient $K^2$ of the Rayleigh wave due to θ of the Eulerian angle in the case where the duty of the IDT electrode was specified to be 0.50, the film thickness of the IDT electrode 3 composed of Au was specified to be 0.062λ, and the film thickness of a $SiO_2$ film serving as the second silicon oxide film 7 was specified to be 0.2λ, 0.3λ, or 0.4λ.

Similarly to Fig. 6, Fig. 7 is a diagram showing changes in electromechanical coefficient $K^2$ of the SH wave due to θ of the Eulerian angle in the case where the film thickness of the IDT electrode 3 composed of Au was specified to be 0.062λ, the duty was specified to be 0.50, and the film thickness of the second silicon oxide film was specified to be 0.20λ, 0.3λ, or 0.4λ.

As is clear from Fig. 6, in every case where the film thickness of the second silicon oxide film is specified to be 0.2±λ, 0.3λ, or 0.4λ, even when the θ of the Eulerian angle is changed, the electromechanical coefficient $K^2$ of the Rayleigh wave does not change to a large extent and shows a high value of 6% or more. On the other hand, as is clear from Fig. 7, the electromechanical coefficient $K^2$ of the SH wave changes significantly as θ of the Eulerian angle changes, and almost the same result is obtained in every case where the film thickness of the second silicon oxide film is specified to be 0.2λ, 0.3λ, or 0.4λ.

Consequently, as is clear from Fig. 6 and Fig. 7, even when the film thickness of the second silicon oxide film 7 is varied because of variations in production and the like, the dependence of the Rayleigh wave and the dependence of the SH wave on θ of the Eulerian angle hardly change. Therefore, according to the above-described embodiment, it is clear that the surface acoustic wave device 1 exhibiting stable characteristics can be provided, wherein variations in influence on the characteristics due to an SH wave spurious do not easily occur even when variations occur in thickness of the second silicon oxide film 7 composed of a $SiO_2$ film.

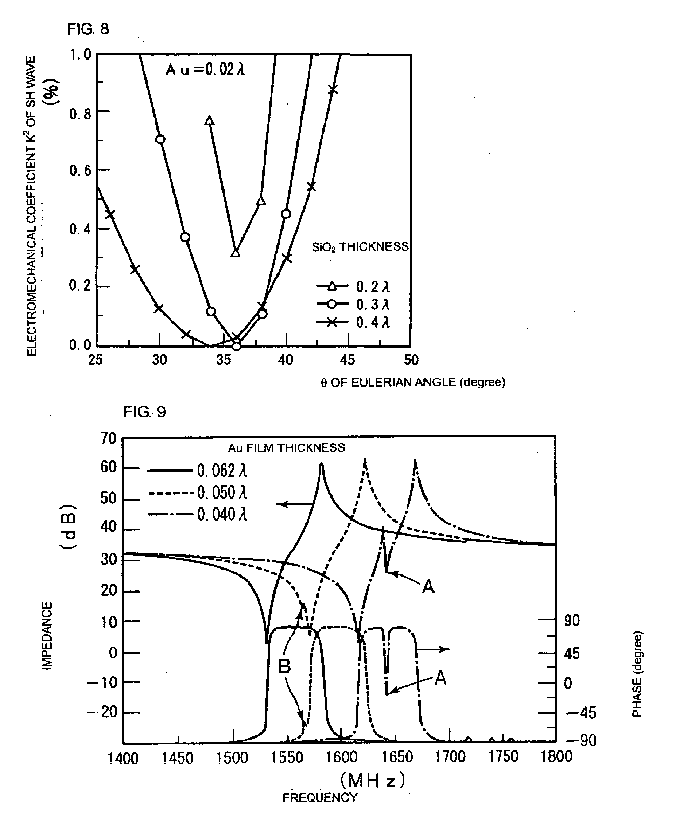

Incidentally, Fig. 8 is a diagram showing changes in electromechanical coefficient $K^2$ of the SH wave due to changes in θ of the Eulerian angle and the film thickness of the second silicon oxide film 7 in the case where the film thickness of the IDT electrode 3 is specified to be 0.02λ.

As is clear from Fig. 8, in the case where the film thickness of the IDT electrode 3 composed of Au is a small 0.02λ, changes in electromechanical coefficient $K^2$ of the SH wave due to θ of the Eulerian angle are very different between the case where the film thickness of the second silicon oxide film 7 is 0.2λ, the case where the film thickness is 0.3λ, and the case where the film thickness is 0.4λ. Consequently, it is clear that in the case where the film thickness of the IDT electrode 3 is a small 0.02λ, if the film thickness of the second silicon oxide film 7 varies, the characteristics vary significantly.

Incidentally, since the SH wave becomes a spurious, it is preferable that the electromechanical coefficient $K^2$ thereof is small. The value of θ at which the electromechanical coefficient $K^2$ of the SH wave becomes a minimum is represented by the following Formula (1), where $T_{Au}$ represents the film thickness of the IDT electrode 3 composed of Au. This Formula (1) was derived from the results shown in the above-described Fig. 3.

[Mathematical formula 3]

$$\theta = 31.72 - 206.92 \times \exp(-1 \times T_{Au}/0.0138) \qquad \text{Formula (1)}$$

where $T_{Au}$: a value of Au electrode film thickness normalized with the wavelength $\lambda$

Furthermore, if the electromechanical coefficient $K^2$ of the SH wave is 0.1% or less, very little influence is exerted by the spurious. Consequently, it is desirable that $\theta$ represented by the above-described Formula (1) is within the range of $\theta \pm 5°$. In that case, the electromechanical coefficient $K^2$ of the SH wave is allowed to become 0.1% or less.

Furthermore, as is clear from Fig. 6, if the film thickness of the second silicon oxide film composed of $SiO_2$ is within the range of $0.2\lambda$ to $0.4\lambda$, the electromechanical coefficient $K^2$ of the Rayleigh wave is allowed to become higher than 6% over a wide range of $\theta$ of the Eulerian angle of 20° to 50°. According to the experiments conducted by the present inventors, it was ascertained that if the film thickness of the second silicon oxide film was within the range of $0.15\lambda$ to $0.5\lambda$, the electromechanical coefficient $K^2$ of the Rayleigh wave was allowed to become 6% or more. Therefore, it is preferable that the film thickness of the second silicon oxide film is specified to be within the range of $0.15\lambda$ to $0.5\lambda$, and more preferably within the range of $0.2\lambda$ to $0.4\lambda$, as shown in Fig. 6.

Fig. 9 shows the impedance characteristics and the phase characteristics of the surface acoustic wave device 1 of the above-described embodiment and surface acoustic wave devices of first and second comparative examples prepared for the purpose of comparison. In the surface acoustic wave device of the embodiment, the IDT electrode 3 was a Au film having a film thickness of $0.05\lambda$. In the first comparative example, the film thickness of the Au film was specified to be $0.05\lambda$, and in the second comparative example, the film thickness of the Au film was specified to be $0.04\lambda$.

Here, the specifications other than the film thickness of the IDT electrode 3 were as described below.

Regarding the surface acoustic wave device of the above-described embodiment, an IDT electrode 3 having a thickness of $0.062\lambda$ = 126 nm was formed on a $LiNbO_3$ substrate 2 represented by Eulerian angles of (0°, 30°, 0°), and a $SiO_2$ film of 600 nm = $0.29\lambda$ was formed as a second silicon oxide film 7, so that a 1.9-GHz-band surface acoustic wave resonator of one-port type was prepared. Here, $\lambda$ = 2.07 $\mu$m was employed.

Regarding the first comparative example, an IDT electrode was formed from a Au film of 104 nm = $0.05\lambda$, and the film thickness of the second silicon oxide film 7 was specified to be 600 nm = $0.29\lambda$. Regarding the second comparative example, the thickness of an IDT electrode composed of Au was specified to be 83 nm = $0.04\lambda$, and the film thickness of a $SiO_2$ film serving as a second silicon oxide film was specified to be 600 nm = $0.29\lambda$. The duty of each of the IDT electrodes was specified to be 0.5.

A solid line indicates the result of the above-described embodiment, a broken line indicates the result of the first comparative example, and an alternate long and short dash line indicates the result of the second comparative example.

As is clear from Fig. 9, in the second comparative example, a large spurious indicated by an arrow A appears between a resonant frequency and an anti-resonant frequency, and in the first comparative example as well, a spurious indicated by an arrow B appears on the lower range side of a resonant frequency. These spuriouses are believed to be spuriouses due to the SH wave. On the other hand, in the surface acoustic wave device 1 of the above-described embodiment, such a spurious is not observed.

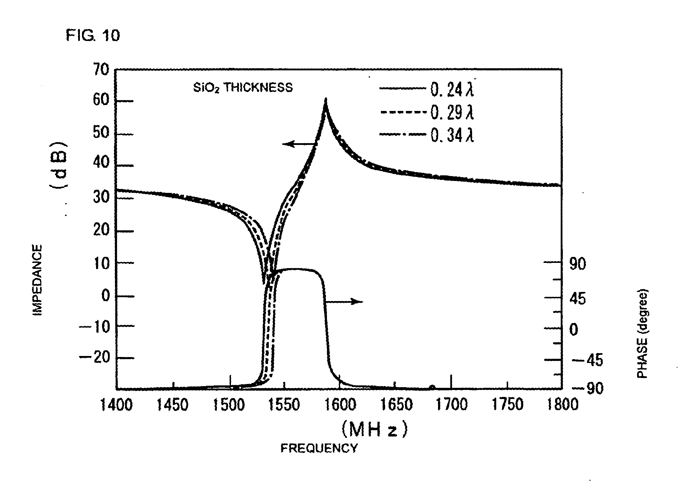

Surface acoustic wave devices were formed as in the above-described embodiment except that the film thickness of the second silicon oxide film 7 in the surface acoustic wave device 1 was changed from $0.34\lambda$ to $0.29\lambda$ and $0.24\lambda$. Fig. 10 shows the measurement results of filter characteristics of these surface acoustic wave devices. As in the above-described embodiment, a solid line indicates the result in the case where the film thickness of the second silicon oxide film is $0.34\lambda$, a broken line indicates the result in the case where the film thickness is $0.29\lambda$, and an alternate long and short dash line indicates the result in the case where the film thickness is $0.24\lambda$.

As is clear from Fig. 10, a spurious is not observed in every case and, therefore, a good resonant characteristic is obtained. Consequently, even when the film thickness of the second silicon oxide film composed of $SiO_2$ varies, a spurious does not appear easily, so that a good resonant characteristic can be obtained stably.

In the above-described embodiment, the Eulerian angles of the $LiNbO_3$ substrate are specified to be (0°, $\theta \pm 5°$, 0°). However, the present inventors ascertained the following by the experiment. That is, regarding the Eulerian angles of ($\phi$ $\theta$, $\varphi$), it is good enough that $\phi$ is within the range of $0° \pm 5°$ and $\varphi$ is within the range of $0° \pm 10°$, and in each case, effects similar to the effects of the above-described embodiment are obtained.

In the above-described embodiment, the IDT electrode is formed from Au. However, in the present invention, it is good enough that an electrode primarily containing Au is used. An adhesion layer having a relatively small thickness may be disposed under a main electrode layer composed of Au, or a thin protective electrode layer may be laminated on an electrode primarily containing Au. In these cases, it is good enough that the thickness of the main electrode layer composed of Au is equal to the thickness of the electrode of the present invention.

Furthermore, the present invention can be applied to not only the above-described one-port surface acoustic wave resonators and band pass filter portions of duplexers, but also various resonators and surface acoustic wave filters having various circuit configurations.

**Claims**

1. A surface acoustic wave device taking advantage of the Rayleigh wave, the device comprising:

   a $LiNbO_3$ substrate (2) represented by Eulerian angles of $(0°\pm5°, \theta\pm5°, 0°\pm10°)$;
   an electrode (3) which is disposed on the $LiNbO_3$ substrate (2) and which includes an IDT electrode primarily containing Au;

   **characterized in that**

   a first silicon oxide film (6) is disposed in a region other than the region in which the electrode (3) is disposed, the first silicon oxide film (6) having a film thickness equal to the thickness of the electrode (3); and
   a second silicon oxide film (7) is disposed in such a way as to cover the electrode (3) and the first silicon oxide film (6), and
   the film thickness of the electrode (3) is within the range of $0.062\lambda$ to $0.14\lambda$, where $\lambda$ represents the wavelength of a surface acoustic wave, and $\theta$ of the Eulerian angles of $(0°\pm5°, \theta\pm5°, 0°\pm10°)$ is specified to be within the range satisfying the following Formula (1)

$$\theta = 31.72 - 206.92 \times \exp(-1 \times T_{Au}/0.0138) \quad \text{Formula (1)}$$

   where $T_{Au}$: a value of Au electrode film thickness normalized with the wavelength $\lambda$.

2. The surface acoustic wave device according to Claim 1, wherein the film thickness H of the second silicon oxide film (7) is specified to be within the range of $0.15\lambda$ to $0.50\lambda$.


**Patentansprüche**

1. Ein Oberflächenwellenbauelement, das die Rayleigh-Welle vorteilhaft nutzt, wobei das Bauelement folgende Merkmale aufweist:

   Ein $LiNbO_3$-Substrat (2), dargestellt durch Eulersche Winkel von $(0°\pm5°, \theta\pm5°, 0°\pm10°)$;
   eine Elektrode (3), die auf dem $LiNbO_3$-Substrat (2) angeordnet ist und die eine IDT-Elektrode umfasst, die primär Au enthält;
   **dadurch gekennzeichnet, dass**
   ein erster Siliziumoxidfilm (6) in einer anderen Region als der Region angeordnet ist, in der die Elektrode (3) angeordnet ist, wobei der erste Siliziumoxidfilm (6) eine Filmdicke gleich der Dicke der Elektrode (3) aufweist; und
   ein zweiter Siliziumoxidfilm (7) derart angeordnet ist, um die Elektrode (3) und den ersten Siliziumoxidfilm (6) abzudecken, und
   die Filmdicke der Elektrode (3) innerhalb des Bereichs von $0{,}062\lambda$ bis $0{,}14\lambda$ ist, wobei $\lambda$ die Wellenlänge einer akustischen Oberflächenwelle darstellt und $\theta$ der Eulerschen Winkel von $(0°\pm5°, \theta\pm5°, 0°\pm10°)$ derart spezifiziert ist, dass es innerhalb des Bereichs ist, der folgende Formel erfüllt (1)

$$\theta = 31{,}72 - 206{,}92 \times \exp(-1 \times T_{Au}/0{,}0138) \quad \text{Formel (1)}$$

   wobei $T_{Au}$: ein Wert einer Au-Elektrode-Filmdicke ist, normiert mit der Wellenlänge $\lambda$.

2. Das Oberflächenwellenbauelement gemäß Anspruch 1, bei dem die Filmdicke H des zweiten Siliziumoxidfilms (7) derart spezifiziert ist, dass sie innerhalb des Bereichs von $0{,}15\lambda$ bis $0{,}50\lambda$ ist.

**Revendications**

1. Dispositif à onde acoustique de surface tirant profit de l'onde de Rayleigh, le dispositif comprenant :

   un substrat de LiNbO$_3$ (2) représenté par des angles eulériens de (0° $\pm$ 5°, θ $\pm$ 5°, 0° $\pm$ 10°) ;
   une électrode (3) qui est disposée sur le substrat de LiNbO$_3$ (2) et qui comprend une électrode IDT contenant principalement de l'Au ;
   **caractérisé en ce que** :
   un premier film d'oxyde de silicium (6) est disposé dans une région autre que la région dans laquelle l'électrode (3) est disposée, le premier film d'oxyde de silicium (6) ayant une épaisseur de film égale à l'épaisseur de l'électrode (3) ; et
   un second film d'oxyde de silicium (7) est disposé de telle manière qu'il recouvre l'électrode (3) et le premier film d'oxyde de silicium (6), et
   l'épaisseur de film de l'électrode (3) se situe dans une plage s'étendant de 0,062 λ à 0,14 λ, où λ représente la longueur d'onde d'une onde acoustique de surface, et la valeur θ des angles eulériens de (0° $\pm$ 5°, θ $\pm$ 5°, 0° $\pm$ 10°) est spécifié pour se situer dans la plage satisfaisant la formule suivante (1) :

$$\theta = 31,72 - 206,92 \times \exp(-1 \times T_{Au}/0,0138) \quad \text{Formule (1)}$$

   où $T_{Au}$ est une valeur d'une épaisseur de film d'électrode d'Au normalisée avec la longueur d'onde λ.

2. Dispositif à onde acoustique de surface selon la revendication 1, dans lequel l'épaisseur de film H du second film d'oxyde de silicium (7) est spécifiée pour se trouver dans la plage s'étendant de 0,15 λ à 0,50 λ.

FIG. 1

(a)

(b)

FIG. 2

FIG. 3

FIG. 4

FIG. 5

.FIG. 6

S i O$_2$=0. 2 $\lambda$

S i O$_2$=0. 3 $\lambda$

S i O$_2$=0. 4 $\lambda$

ELECTROMECHANICAL COEFFICIENT K$^2$ OF RAYLEIGH WAVE (%)

$\theta$ OF EULERIAN ANGLE (degree)

FIG. 7

A u =0. 062 $\lambda$

SiO$_2$ THICKNESS

—△— 0. 2 $\lambda$
—○— 0. 3 $\lambda$
—✕— 0. 4 $\lambda$

ELECTROMECHANICAL COEFFICIENT K$^2$ OF SH WAVE (%)

$\theta$ OF EULERIAN ANGLE (degree)

FIG. 8

FIG. 9

FIG. 10

## REFERENCES CITED IN THE DESCRIPTION

### Patent documents cited in the description

- WO 2005034347 A
- JP 2005354430 A